# EUROPEAN PATENT APPLICATION

(11) **EP 0 670 600 A2**
(43) Date of publication of application: **06.09.1995**
(21) Application number: 95301222.6
(22) Date of filing: 24.02.1995
(51) Int. Cl.: H01L 27/02

(54) **Insulated gate-type bipolar transistor**

(30) Priority: 01.03.1994 JP 30723/94
(71) Applicant: FUJI ELECTRIC CO. LTD., Kawasaki 210 (JP)
(72) Inventor: Yamazaki, Tomoyuki, c/o Fuji Electric Co. Ltd., Kawasaki 210 (JP); Otsuki, Masahito, c/o Fuji Electric Co. Ltd., Kawasaki 210 (JP)
(74) Representative: Topley, Paul

(57) **Abstract**

To provide an insulated gate-type bipolar transistor with an overcurrent limiting function that is capable of keeping the ratio of a main current to a detection current constant even under different operating conditions, and is capable of suppressing the voltage dependence of the value of the limited current to perform stable overcurrent protection, P-wells (9) are formed so that they are incorporated between main cell IGBTs (6) as sensing cells for current detection on part of the semiconductor substrate (5) on which a large number of main cells are formed integrally, and current-detecting emitter electrodes (10) connected to the P-wells are connected to an overcurrent-protection circuit and separated from the main emitter electrodes (7) connected to the main IGBT cells. Given such a configuration, the overcurrent flowing into the main cells during a load short circuit in an inverter device is accurately detected as a hole current from the P-wells with the current ratio to the current in the main cells remaining constant, and moreover, stable overcurrent protection is performed keeping the limited current values suppressed below the short-circuit withstand capability without dependence on the power supply voltage.

## Description

The present invention relates to semiconductors, and is particularly concerned with an insulated gate-type bipolar transistor (IGBT) which can act as a power-switching device. The device is applicable to inverters and other similar devices.

An insulated gate-type bipolar transistor (hereinafter referred to as IGBT) is a voltage-driven semiconductor switching device capable of a high-speed turning-off operation with relatively low voltage application, which is used widely in the field of power electronics, for example, in inverters and other similar devices.

An IGBT output-type inverter device may have an overcurrent flow into the IGBT if there is an inrush current when a motor is actuated, and a failure such as a load short circuit or an arm short circuit occurs. Hence, superior electrical characteristics are required for the IGBT against a high voltage and large current, and among the electrical characteristics especially required is a breakdown withstand capability known as a short-circuit withstand capability.

Conventionally, an inverter device incorporates a protection circuit to detect short-circuit failures, and turn the power supply off when they occur. Such a protection circuit generally requires from 10 to 20µsec to detect the overcurrent and then to cut off the power supply, and it is imperative that the IGBT must not break down during this time.

Therefore, many recent high-performance IGBT modules adopt an overcurrent-protection system which is disposed independently of the protection circuit in the inverter device, and which can quickly detect an overcurrent flowing into the IGBT when a short-circuit failure occurs, and can then limit the current in the IGBT and suppress it to within the short-circuit withstand capability of the elements. This is achieved by means of a gate control based on this overcurrent detection signal before the power supply is turned off by said protection circuit.

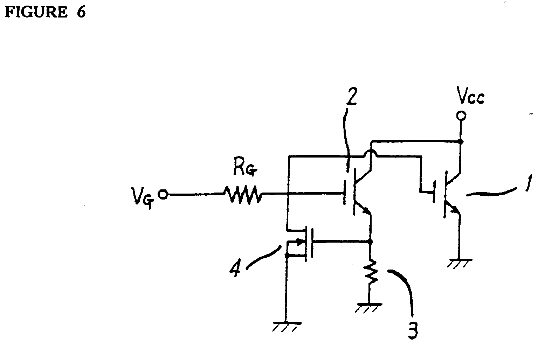

Figure 6 shows an IGBT overcurrent-protection circuit incorporating the overcurrent protection system described above. In the Figure, a main element (IGBT) 1 has a current-detection sub-element 2 (a different IGBT from the main element 1) connected in parallel to the main element 1. A current-detection resistor 3 is connected in series with the sub-element 2, and a switching element (MOSFET) 4 is connected to the gate-driving circuits for the main element 1 and the sub-element 2 to perform on-off operation according to the voltage generated at the ends of the current-detection resistor 3.

Given such a configuration, when an overcurrent due to a load short-circuit failure or the like flows into the main element 1 and the sub-element 2, the voltage drop generated between the ends of the current-detection resistor 3 exceeds the threshold voltage of the switching element 4 and the switching element 4 turns on to reduce the gate voltage of both the main element 1 and the current-detection sub-element 2. The main current flowing in the IGBT main element is thus limited. In this case, the main current flowing in the IGBT main element to be protected can be suppressed to within the short-circuit withstand capability of the IGBT element by selecting appropriate values for the resistance of the current-detection resistor 3 and the threshold voltage of the switching element 4.

In the meantime, when an overcurrent-protection circuit that includes the IGBT sub-element 2 for current detection is constructed as an external, independent circuit to protect the IGBT main element 1 as described above, it is technically difficult to maintain the operational characteristics of the main element 1 proportional to those of the sub-element 2. In other words, since a short-circuit phenomenon in an inverter can occur in one of a number of ways, such as an arm short circuit, a series short circuit, an output short circuit and an earth fault, and it is anticipated that the collector-to-emitter voltage V_{CE} applied to the IGBT element to be protected will vary according to the nature of the short-circuit mode, then the current ratio between the main element 1 and the sub-element 2 may vary, and so may the value of the limited current if the collector-to-emitter voltage V_{CE} varies as described above, making a stable overcurrent-protection operation difficult.

To solve the above problem, a configuration has already been proposed in European Patent Application 94.307477.3, wherein some of the cells formed integrally on a semiconductor substrate are used as sensing cells to detect the current in the IGBT main element, and the emitter electrodes of said sensing cells are laid out separately from the emitter electrodes of the main cells formed on the same substrate and connected to a current-detection resistor in an overcurrent protection circuit.

In the construction that incorporates the main cells (IGBT) and the current detection sensing cells (IGBT) on the same semiconductor substrate as described above, the electrical potential at the gate of the sensing cell may change with a voltage drop at the resistor of the overcurrent-protection circuit which is connected to the sensing cells, depending on the positioning of the sensing cells and on the IGBT output characteristics. The change in the gate electrical potential generates a difference in the current density between the main cells and the sensing cells, causing the current ratio between the main cells and the sensing cells to vary. Experimental results have shown that a change in the collector-to-emitter voltage V_{CE} due to the current ratio variation also causes the value of the limited current to change. In particular the value of the limited currents increase in a low voltage region in which the collector-to-emitter voltage V_{CE} is low.

Moreover, if the voltage dependence of the value of the limited current increases, the avercurrent protection operation may suffer if the IGBT forms part of an inverter device. Hence, it is necessary to suppress the voltage dependence of the value of the limited current, to keep its variation as small as possible.

The present invention is intended to solve the above problems, and to provide an insulated gate-type bipolar transistor with an overcurrent-limiting function that is capable of keeping the ratio of the main current to the detection current constant even in different operating environments, while at the same time suppressing the voltage dependence of the value of the limited current to ensure reliable overcurrent protection.

According to the present invention, an insulated gate-type bipolar transistor comprises a semiconductor substrate on which a large number of main cells are formed integrally, and has a number of current-detection sensing cells formed in part of the semiconductor substrate, the emitter electrodes of said sensing cells being separated from the emitter electrodes of the main cells and being connected to an overcurrent protection circuit, wherein said sensing cells are formed by means of P-wells, and are laid out in the vicinity of the main cell region.

In the above configuration, the P-wells connected to the emitter electrodes of the sensing cells may be formed in such a way that they are incorporated between the main cells, with the distance between the P-wells and the adjoining main cells preferably arranged to be about 10µm or less.

In the above configuration, the P-wells that form the sensing cells to detect the current are positioned in the active region of the main cells on the same semiconductor substrate, and a current proportional to the hole current flowing in the main cells is extracted via the P-wells during the IGBT voltage-on period, and is detected with high accuracy by a current-detection resistor in the overcurrent-protection circuit connected to the emitter electrodes of the sensing cells. When an overcurrent flows as a result of the load short circuit or some similar phenomenon, the gate voltage of the main cells is reduced by the operation of the protection circuit to limit the main current to a value within the short-circuit withstand capability of the IGBT, thereby protecting the cells from a breakdown.

In addition, forming the sensing cells by means of the P-wells in this case eliminates the change in the current ratio between the main cells and the sensing cells, which occurs when an IGBT is used for the sensing cells, and the voltage dependence of the value of the limited current caused by the change in this current ratio is effectively suppressed. Furthermore, by laying out the P-wells connected to the emitter electrodes of the sensing cells so that they are incorporated in narrow clearances between the main cells, the linearity of the current in the sensing cells to the hole current in the adjoining main cells can be ensured, resulting in greatly improved accuracy in detecting the main current.

Embodiments of the present invention will now be explained in detail, with reference to the accompanying drawings, in which;
Figure 1(a) is a plan view of a chip showing the configuration of an insulated gate-type bipolar transistor according to an embodiment of the present invention;
Figure 1(b) is a cross-sectional view of IGBTs formed in the chip of Figure 1(a);
Figure 2 is an enlarged view of sensing cells in the chip shown in Figure 1;
Figure 3 is an enlarged view of sensing cells in the chip to show an applied embodiment of the present invention;
Figure 4 is a voltage and current waveform chart observed in a load short-circuit test performed by connecting a protection circuit to the IGBT in Figure 1;
Figure 5 is a characteristics graph illustrating the relationship between the power supply voltage and the value of the limited current by comparing an embodiment of the present invention with the prior art; and
Figure 6 is a diagram of an overcurrent-protection circuit in a conventional IGBT.

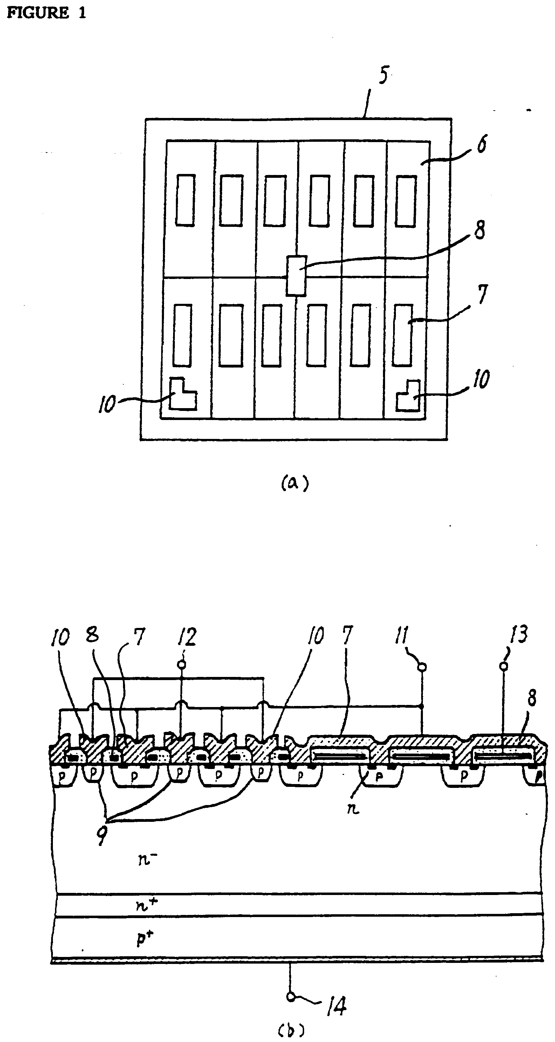

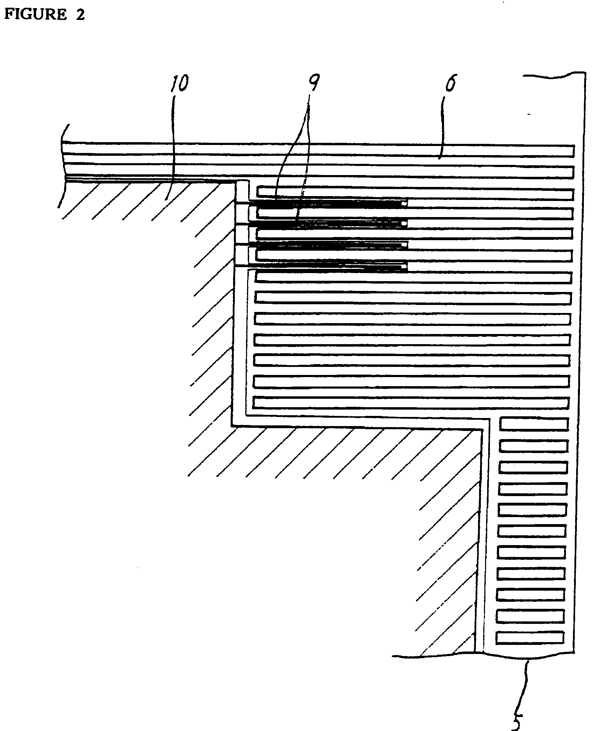

Referring now to the drawings, Figures 1 (a) and (b) are a plan view of an IGBT chip and a cross-sectional view of a cell, respectively, and Figure 2 is an enlarged view of the sensing cells of the IGBT chip in Figure 1. The semiconductor substrate 5 has a large number of n-channel type IGBTs (main cells) 6 which are laid out in parallel rows. The main emitter electrodes 7 and the gate electrodes 8 are connected to the emitters and gates, respectively, of the IGBTs of the main cells 6. In addition, the current-detection sensing cells as described below are incorporated in the corners of the semiconductor substrate 5.

This sensing cell consists of diffusion-formed elongated P-wells 9 which are inserted like comb teeth between, and parallel to, the stripes of p-base layers of the main cell IGBTs. The emitter electrodes 10 connected to the current detection P-wells 9 are separated from the emitter electrodes 7 of the main cells, as is shown in Figure 1 (b) and Figure 2. In this case, the IGBTs 6 of the main cells and the P-wells 9 running parallel therewith are preferably arranged in proximity to each other with the distance between them being about 10µm or less, though this distance will vary in dependance on the resistivity of the semiconductor substrate 5. In addition, the gate electrode 8 of the main cells is divided at the part where the emitter electrodes 10 are lead out from the P-wells 9, as shown in Figure 1 (b).

Furthermore, in Figure 1 (b), part 11 is a main emitter terminal, 12 is a current-detection emitter terminal, 13 is a gate terminal, and 14 is a collector terminal. The current-detection emitter terminal 12 is connected to the current-detection resistor 3 in the overcurrent-protection circuit in the manner shown in Figure 6. The current-detection resistor 3 and the sub-element MOSFET 4 that constitute the overcurrent-detection circuit may be constructed as an external circuit separated from the IGBTs, or may be integrally formed to surround the gate electrode on the semiconductor substrate 5.

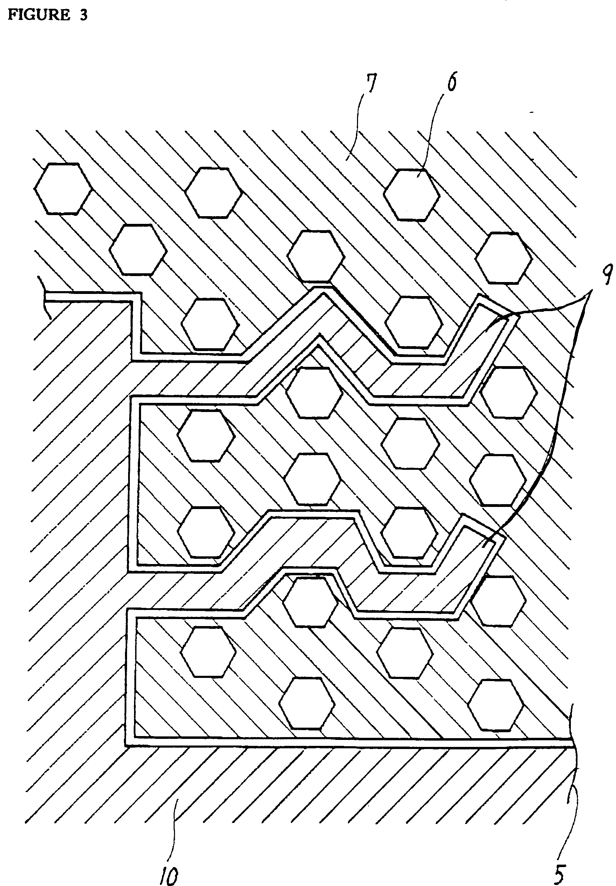

Figure 3 shows a second embodiment where the IGBTs 6 of the main cells are hexagonal in form, and are spaced apart over the substrate in a regular array. In this embodiment, the elongated P-wells 9 of the sensing cells run in zigzag fashion between the main cells.

The overcurrent-protection operation of the IGBT according to the second embodiment is nearly the same as occurs in the circuit illustrated in Figure 6. The overcurrent flowing in the main cell IGBT is detected as a positive-hole current by means of the P-wells 9 of the current-detection sensing cells formed on the same semiconductor substrate 5, and the detected current is fed back to the overcurrent-protection circuit which then reduces the gate voltage so that the overcurrent is restricted to within the short-circuit withstand capability. In addition, because the P-wells 9 for the sensing cells are arranged in close proximity to the active region of the main cell IGBT 6, the on-state voltage for this main cell is higher than that for the other main cells. Hence, no current concentration occurs in this area. Furthermore, since latch-up phenomenon is prevented as a result of forming the sensing cells with P-wells, the breakdown withstand capability improves in this area.

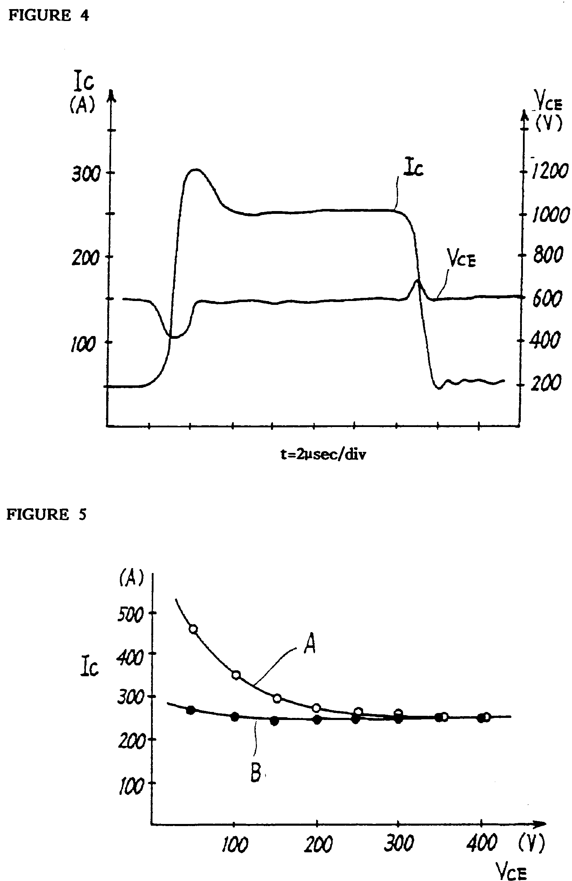

Next, Figure 4 shows the waveforms of the main current Ic and the voltage V_{CE} observed in a short-circuit test using the overcurrent-protection circuit connected to the IGBT with the above configuration (with a withstand voltage of 600V, and a rated current of 100A) and using a power supply voltage of 400V. As can be seen from this waveform graph, the main current in the IGBT is reduced in a period of a few microseccnds so that the value of the limited current relative to the rated current of 100A is within the short-circuit withstand capability of 250A.

Figure 5 is a characteristics graph that illustrates the limited current values of an overcurrent when the power supply voltage applied across the collector and the emitter changes, in order to compare the embodiment of the present invention with a conventional system (a system using an IGBT as a sensing cell). The tested IGBT shown in this graph is an element with a large gain. The prior art devices applying this type of element show a trend in which the value of the limited current increases in a low voltage region as shown by the line "A", while in the present invention the value of the limited current changes very little and remains the same from a high voltage region to low voltage region as shown by the line "B". This means that the voltage dependence of the value of the limited current is greatly reduced. This effect stabilizes overcurrent protection when the IGBT is used in an inverter device regardless of the manner in which the short-circuit may take place.

As described above, the insulated gate-type bipolar transistor according to the present invention, is characterised in that sensing cells for current detection are formed on part of a semiconductor substrate with a large number of main cells that are formed integrally, and the emitter electrodes of said sensing cells are laid out separately from the emitter electrodes of the main cells and are connected to an overcurrent-protection circuit. An overcurrent that flows into the main cells due to a load short circuit in an inverter device is detected as a hole current with high accuracy from P-wells while the current ratio between the main cells and the sensing cells is maintained constant because of a constrution in which the sensing cells are formed by the P-wells and the sensing cells are laid out in the vicinity of the main cell region. The value of the limited current is suppressed to within the short-circuit withstand capability without dependence on the power supply voltage because of this construction, which in turn makes stable overcurrent protection possible.

Furthermore, by forming the P-wells connected to the emitter electrodes of the sensing cells and by incorporating them between the main cells, and by setting the distance between the P-wells and their adjoining main cells to about 10µm or less, linearity of the sensing cell current to the hole current in the main cells is ensured, thereby further improving the current detection accuracy.

## Claims

1. An insulated gate-type bipolar transistor characterised in that sensing cells for current detection are formed in part of a semiconductor substrate (5) on which a large number of main cells (6) are formed integrally, and emitter electrodes (10) of said sensing cells are separated fran the emitter electrodes (7) of the main cells (6) and connected to an overcurrent protection circuit, and that said sensing cells are formed by means of P-wells (9) and laid out in the vicinity of the main cell (6) region.

2. An insulated gate-type bipolar transistor as claimed in Claim 1, characterised in that the P-wells (9) connected to the emitter electrodes (10) of the sensing cells are formed so that they are incorporated between the main cells (6).

3. An insulated gate-type bipolar transistor as claimed in Claim 1 or 2, characterised in that the distance between the P-wells (9) and their respective adjacent main cells (6) is set to about 10µm or less.
